# EUROPEAN PATENT APPLICATION

(11) **EP 2 246 862 A1**
(43) Date of publication of application: **03.11.2010**
(21) Application number: 09005812.4
(22) Date of filing: 27.04.2009
(51) Int. Cl.: H01B 1/12

(54) **Organic electronic device comprising an organic semiconducting material**

(71) Applicant: Novaled AG, 01307 Dresden (DE)
(72) Inventor: Hartmann, Horst Prof. Dr., 01326 Dresden (DE); Fadhel, Omrane, 01099 Dresden (DE)
(74) Representative: Bittner, Thomas L.

(57) **Abstract**

The present invention relates to an organic electronic device comprising an organic semiconducting material comprising at least one compound according to the formulae (I) to (VII).

## Description

The present invention relates to an organic electronic device comprising an organic semiconducting material.

### Field of the invention

Conjugated organic compounds have different applications. One important field comprises organic semiconductors. Organic semiconductors can be used to fabricate simple electronic components e.g. resistors, diodes, field effect transistors, and also optoelectronic components like organic light emitting devices (e.g. OLED), solar cells, and many others. Non-volatile and volatile, re-writable memories can be created using many different physical mechanisms, such as molecular bi-stability, ferromagnetic properties (e.g. US2006073658), ion transfer and charge wells (e.g. WO08125100). The industrial and economical significance of the organic semiconductors and their devices is reflected in the increased number of devices using organic semiconducting active layers and the increasing industry focus on the subject.

A simple OLED is demonstrated in US4356429A. There, between conductive electrodes, two semiconductive organic layers are brought together: one transporting holes and the other one transporting electrons. The recombination of holes and electrons forms excitons in one or both of the organic layers, the excitons are eventually emitted following the spin statistics. Excitons with triplet spin can also be harvested by using the materials and techniques described in EP1705727. More elaborated OLEDs are described in EP1804309 and US2008182129.

A simple, two layer, organic solar cell is described in US4164431 A. Many different solar cells use organic layers, for instance, Grätzel cells, polymer cells and small molecule solar cells. Many different approaches are tried out to increase the conversion performance; the so called bulk heterojunction solar cells have reached around 5 % conversion efficiency.

Conjugated organic compounds can be small molecules, for instance monomers, or oligomers, polymers, copolymers, copolymers of conjugated and non-conjugated blocks, completely or partially cross-linked layers, aggregate structures, or brush like structures. A device made with different types of compounds, in different layers or mixed together, for example with polymer and small molecule layers, is also called a polymer - small molecule hybrid device.

Organic electronic semiconductors can be used in organic electronic devices, and in organic- inorganic hybrid devices.

Despite the large electronic gap, usually up to 3 eV, formed between the highest occupied molecular orbital (HOMO) and the lowest unoccupied molecular orbital (LUMO) of the molecule, it is normally still low enough such that both positive and negative charge carriers can be injected by special electrodes. Typical organic semiconducting compounds may have a gap that is still high enough so that the compounds are optically active.

Organic field effect transistors are explained, for example, in US7026643, US2005146262 and US2008230776. The resistance of a semiconductive layer that is contacted by two electrodes (source and drain) can be controlled by the voltage that is applied to the gate. The gate is displaced on an insulator that is displaced parallel in contact to the semiconductive layer. Various geometries can be used, such as bottom gate (on the substrate), top gate (on the opposite side of the semiconductive layer relative to the substrate) or on both sides. Many different arrangements of layers can be used such as bipolar layers, injection layer, insulating layer between electrode and semiconductive layer to lower the off current, etc.

### Background of the invention

Different functional layers in different organic semiconductor devices request a variety of special characteristics.

For instance organic thin-film transistors (OTFTs) need high mobility materials in their active channel. Transparent circuits, such as transparent OTFTs require that the high mobility organic material also comprises a wide electronic band gap; the electric injection of holes and / or electrons must be still provided.

Solar cells and OLEDs require transparent transport layers, with high conductivity. The transparency is necessary in those opto-electric devices to avoid non desired absorption of the light. These so called "window" materials can be used as transport layers, exciton or charge blocking layers. The thickness of the layers made with the window materials is used to adjust the micro cavity of the OLEDs and solar cells in such a way that the outcoupled emission of the OLED is a maximum, and in the case of the solar cell, the absorption and respective photocurrent of the device is a maximum. The non-optically active layers of all kinds of semiconductor devices can be exchanged for window materials in order to fabricate fully transparent components and circuits (e.g US20060033115).

The functionality and nomenclature of the layers are typical as used in the field. Further explanation can be found in US2006244370.

Electronic devices also need high stability towards temperature, meaning that the intrinsic properties of the amorphous organic semiconducting materials, such as triphenyl amine derivatives, or phenantronine derivatives, must include a high glass transition temperature (Tg) and high temperature stability in the device.

The conductivity can be, for example, measured by the so-called 2-point or 4-point-method. Here, contacts of a conductive material, such as gold or indium-tin-oxide, are disposed on a substrate. Then, the thin film to be examined is applied onto the substrate, so that the contacts are covered by the thin film. After applying a voltage to the contacts the current is measured. From the geometry of the contacts and the thickness of the sample the resistance and therefore the conductivity of the thin film material can be determined. The four point or two point method give the same conductivity values for doped layers since the doped layers grant a good ohmic contact.

The temperature stability can be also measured with that method in that the (undoped or doped) layer is heated stepwise, and after a waiting period the conductivity is measured. The maximum temperature, which can be applied to the layer without loosing the desired semiconducting properties, is then the temperature just before the conductivity breaks down. For example, a doped layer can be heated on the substrate with two electrodes, as disclosed above, in steps of 1°C, wherein after each step there is a waiting period of 10 seconds. Then the conductivity is measured. The conductivity changes with temperature and breaks down abruptly at a particular temperature. The temperature stability is therefore the temperature up to which the conductivity does not break down abruptly. The measurement is performed in vacuum.

The properties of the many different used materials can be described by the position of their highest occupied molecular orbital energy level (HOMO, synonym of ionization potential), and the lowest unoccupied molecular orbital energy level (LUMO, synonym of electron affinity).

A method to determine the ionization potentials (IP) is the ultraviolet photo spectroscopy (UPS). It is usual to measure the ionization potential for solid state materials; however, it is also possible to measure the IP in the gas phase. Both values are differentiated by their solid state effects, which are, for example the polarization energy of the holes that are created during the photo ionization process. A typical value for the polarization energy is approximately 1 eV, but larger discrepancies of the values can also occur. The IP is related to beginning of the photoemission spectra in the region of the large kinetic energy of the photoelectrons, i.e. the energy of the most weakly bounded electrons. A related method to UPS, the inverted photo electron spectroscopy (IPES) can be used to determine the electron affinity (EA). However, this method is less common. Electrochemical measurements in solution are an alternative to the determination of solid state oxidation (Eox) and reduction (Ered) potential. An adequate method is for example the cyclo-voltammetry. Empiric methods for the extraction of the solid state ionization potentials are known from the literature. There are no known empiric equations for the conversion of reduction potentials into electron affinities. The reason for that is the difficulty of the determination of the electron affinity. Therefore, a simple rule is used very often: IP=4.8 eV+ e*Eox (vs. Ferrocen/Ferrocenium) and EA=4.8eV +e*Ered (vs. Ferrocen/Ferrocenium) respectively (see B.W. Andrade, Org. Electron. 6, 11 (2005) and Refs. 25-28 therein). Processes are known for the correction of the electrochemical potentials in the case other reference electrodes or other redox pairs are used (see A.J. Bard, L.R. Faulkner, "Electrochemical Methods: Fundamentals and Applications", Wiley, 2. Ausgabe 2000). The information about the influence of the solution used can be found in N.G. Connelly et al., Chem. Rev. 96, 877 (1996). It is usual, even if not exactly correct to use the terms "energy of the HOMO" E(HOMO) and "energy of the LUMO" E(LUMO) respectively as synonyms for the ionization energy and electron affinity (Koopmans Theorem). It has to be taken in consideration, that the ionization potentials and the electron affinities are given in such a way that a larger value represents a stronger binding of a released or respectively of an absorbed electron. The energy scale of the molecular orbitals (HOMO, LUMO) is opposed to this. Therefore, in a rough approximation, is valid: IP=-E(HOMO) and EA=E(LUMO). The given potentials correspond to the solid-state potentials. Hole transport layers, including the respective blockers, mostly have HOMO in the range from -4.5 to -5.5 eV (below the vacuum level) and LUMO in the range of -1.5 eV to -3 eV. The HOMO levels of the emitter materials are in the range of -5 eV to -6.5 eV, and the LUMO in the range from -2 to -3 eV. Electron transport materials, including their respective blockers, have their HOMO in a range of -5.5 eV to -6.8 eV and LUMO in the range of -2.3 eV to -3.3 eV, larger (lower laying) LUMO and HOMO levels may be required for solar cells. The work function of the contact materials is around -4 to -5 eV for the anode and -3 to -4.5 eV for the cathode.

The performance characteristics of (opto)electronic multilayered components are determined by the ability of the layers to transport the charge carriers, amongst others. In the case of light-emitting diodes, the ohmic losses in the charge transport layers during operation are associated with their conductivity. The conductivity directly influences the operating voltage required and also determines the thermal load of the component. Furthermore, depending on the charge carrier concentration in the organic layers, bending of the band in the vicinity of a metal contact results which simplifies the injection of charge carriers and can therefore reduce the contact resistance. Similar deliberations in terms of organic solar cells also lead to the conclusion that their efficiency is also determined by the transport and extraction to the electrode properties of charge carriers.

By electrically doping hole transport layers with a suitable acceptor material (p-doping) or electron transport layers with a donor material (n-doping), respectively, the density of charge carriers in organic solids (and therefore the conductivity) can be increased substantially. Additionally, analogous to the experience with inorganic semiconductors, applications can be anticipated which are precisely based on the use of p- and n-doped layers in a component and otherwise would be not conceivable. The use of doped charge-carrier transport layers (p-doping of the hole transport layer by admixture of acceptor-like molecules, n-doping of the electron transport layer by admixture of donor-like molecules) in organic light-emitting diodes is described in US2008203406 and US 5,093,698.

US2008227979 discloses in detail the doping of organic transport materials, also called matrix, with inorganic and with organic dopants. Basically, an effective electronic transfer occurs from the dopant to the matrix increasing the Fermi level of the matrix. For an efficient transfer in a p-doping case, the LUMO energy level of the dopant must be more negative than the HOMO energy level of the matrix or at least slightly more positive, not more than 0.5 eV, to the HOMO energy level of the matrix. For the n-doping case, the HOMO energy level of the dopant must be more positive than the LUMO energy level of the matrix or at least slightly more negative, not lower than 0.5 eV, to the LUMO energy level of the matrix. It is furthermore desired that the energy level difference for energy transfer from dopant to matrix is smaller than + 0.3 eV.

The dopant donor is a molecule or a neutral radical or combination thereof with a HOMO energy level (ionization potential in solid state) more positive than -3.3 eV, preferably more positive than -2.8 eV, more preferably more positive than -2.6 eV and its respective gas phase ionization potential is more positive than -4.3 eV, preferably more positive than -3.8 eV, more preferably more positive than -3.6 eV. The HOMO of the donor can be estimated by cyclo-voltammetric measurements. An alternative way to measure the reduction potential is to measure the cation of the donor salt. The donor has to exhibit an oxidation potential that is smaller than or equal to -1.5 V vs Fc / Fc+ (Ferrum/Ferrocenium redox-pair), preferably smaller than -1.5 V, more preferably smaller than or equal to approximately -2.0 V, even more preferably smaller than or equal to -2.2 V. The molar mass of the donor is in a range between 100 and 2000 g/mol, preferably in a range from 200 and 1000 g / mol. The molar doping concentration is in the range of 1:10000 (dopant molecule : matrix molecule) and 1:2, preferably between 1:100 and 1:5, more preferably between 1:100 and 1:10. In individual cases doping concentrations larger than 1:2 are applied, e.g. if large conductivities are required. The donor can be created by a precursor during the layer forming (deposition) process or during a subsequent process of layer formation (see DE 10307125.3). The above given value of the HOMO level of the donor refers to the resulting molecule or molecule radical.

A dopant acceptor is a molecule or a neutral radical or combination thereof with a LUMO level more negative than -4.5 eV, preferably more negative than -4.8 eV, more preferably more negative than -5.04 eV. The LUMO of the acceptor can be estimated by cyclo-voltammetric measurements. The acceptor has to exhibit a reduction potential that is larger than or equal to approximately -0.3 V vs Fc / Fc+ (Ferrum/Ferrocenium redox-pair), preferably larger than or equal to 0.0 V, preferably larger than or equal to 0.24 V. The molar mass of the aceptor is preferably in the range of 100 to 2000 g / mol, more preferably between 200 and 1000 g / mol, and even more preferably between 300 g/mol and 2000 g/mol. The molar doping concentration is in the range of 1:10000 (dopant molecule : matrix molecule) and 1:2, preferably between 1:100 and 1:5, more preferably between 1:100 and 1:10. In individual cases doping concentrations larger than 1:2 are applied, e.g. if large conductivities are required. The acceptor can be created by a precursor during the layer forming (deposition) process or during a subsequent process of layer formation. The above given value of the LUMO level of the acceptor refers to the resulting molecule or molecule radical.

Typical examples of doped hole transport materials are: copperphthalocyanine (CuPc), which HOMO level is approximately -5.2 eV, doped with tetrafluoro-tetracyanoquinonedimethane (F4TCNQ), which LUMO level is about -5.2 eV; zincphthalocyanine (ZnPc) (HOMO = -5.2 eV) doped with F4TCNQ; pentacene, with its HOMO around -4.6 eV, doped with tris {2, 5 - bis ( 3, 5 - bis - trifluoromethyl - phenyl ) - thieno } [ 3, 4 - b, h, n ] - 1, 4, 5, 8, 9, 12 - hexaazatriphenylene, which has its LUMO level at about -4.6 eV; a-NPD (N,N'-Bis(naphthalen-1-yl)-N,N'-bis(phenyl)-benzidine) doped with 2,2'-(perfluoronaphthalene-2,6-diylidene) dimalononitrile.

Typical examples of doped electron transport materials are: fullerene C60 doped with acridine orange base (AOB); perylene-3,4,9,10-tetracarboxylic-3,4,9,10-dianhydride (PTCDA) doped with leuco crystal violet; 2,9 - di (phenanthren-9-yl) - 4,7 - diphenyl - 1,10 - phenanthroline doped with tetrakis ( 1,3,4,6,7,8 - hexahydro - 2H - pyrimido [ 1,2 - a] pyrimidinato) ditungsten (II) (W(hpp)₄); naphthalene tetracarboxylic acid di-anhydride (NTCDA) doped with 3,6-bis-(dimethyl amino)-acridine; NTCDA doped with bis(ethylene-dithio) tetrathiafulvalene (BEDT-TTF).

Preferably n-dopants are: 2,2'-diisopropyl-1,1',3,3'-tetramethyl-2,2',3,3',4,4',5,5',6,6',7,7'-dodecahydro-1H, 1'H- 2,2' - dibenzo[d]imidazole; 4,4',5,5'-tetracyclohexyl-1,1',2,2',3,3'-hexamethyl-2,2',3,3'-tetrahydro-1H,1'H-2,2'-bisimidazole; 2,2' - diisopropyl - 4,4',5,5' - tetrakis (4 - methoxyphenyl ) -1,1',3,3' - tetramethyl - 2,2',3,3' - tetrahydro - 1H,1'H - 2,2' - bisimidazole; 2-isopropyl-1,3-dimethyl-2,3,6,7-tetrahydro-1H-5,8-dioxa-1,3-diaza-cyclopenta[b]naphthene; bis-[1,3-dimethyl-2-isopropyl-1,2-dihydro-benzimidazolyl-(2)]; tetrakis(1,3,4,6,7,8-hexahydro-2H-pyrimido[1,2-a]pyrimidinato)ditungsten (II); 2,2'-diisopropyl-4,5-bis-(2-methoxyphenyl) - 4',5' - bis (4 - methoxyphenyl) - 1,1',3,3' - tetramethyl-2,2',3,3' - tetrahydro - 1H,1'H - 2,2' - bisimidazole; 2,2' - diisopropyl - 4,5 - bis(2-methoxyphenyl) -4',5' - bis (3 - methoxyphenyl) - 1,1',3,3' - tetramethyl - 2,2',3,3' - tetrahydro - 1H,1'H-2,2'- bisimidazole.

By using the term doping it is meant electrical doping as explained above. This doping can also be called redox-doping or charge transfer doping. It is known that the doping increases the density of charge carriers of a semiconducting matrix towards the charge carrier density of the undoped matrix. An electrically doped semiconductor layer also has an increased effective mobility in comparison with the undoped semiconductor matrix.

There is a technical challenge to provide electron transport materials (ETM) and emitter host (EMH) materials that have a sufficiently low laying LUMO level so that they can be doped, and still have a high enough laying LUMO level which can efficiently transfer charge to emitter host (in case of an ETM) and transfer energy to the emitter dopant (in case of EMH). The limitation for high laying LUMO level of the ETL is given by the dopability, since the n-dopants with very high HOMO tend to be unstable; also the injection is difficult for very high LUMO of the ETL.

A technical challenge for organic solar cells is to provide electron transport materials with low laying LUMO level that can easily align with the LUMO of the heterojunction acceptor of the solar cell. Furthermore, materials are required with the low laying LUMO level and a very low laying HOMO level that can be used to block holes.

### Summary of the invention

It is an object of the present invention to provide an organic electronic device comprising a specific class of functional materials which can be utilized as organic semiconducting materials to overcome the drawbacks of the prior art. Especially, an organic electronic device shall be provided comprising transparent organic semiconducting materials which are additionally thermally stable and/or dopable. Further, the organic electronic device shall comprise semiconducting materials which can be synthesized without any difficulties and do not complex any metal dopands.

This object is achieved by an organic electronic device comprising an organic semiconducting material comprising at least one compound according to the following formulae: 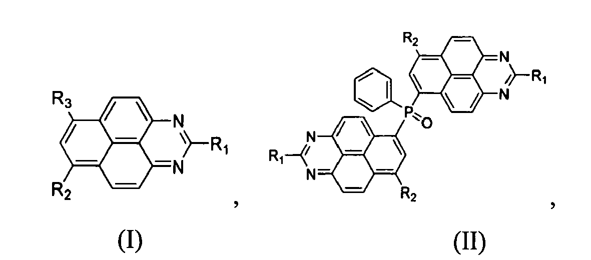 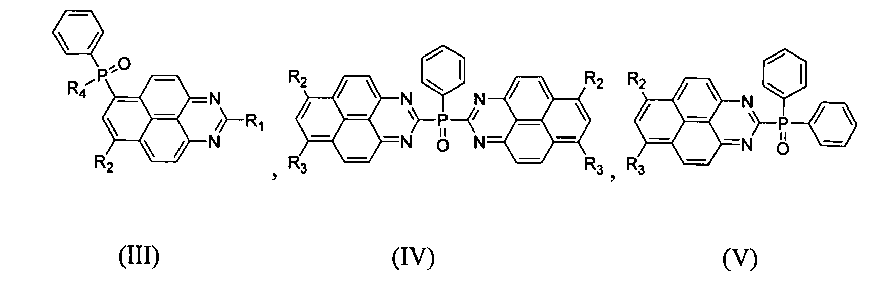 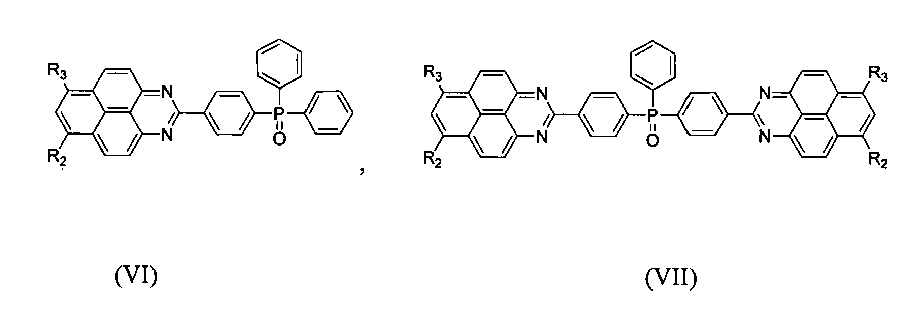 wherein R₁, R₂, R₃, and R₄ are in each occurrence independently selected from H, halogen, CN, substituted or unsubstituted aryl, heteroaryl, alkyl, heteroalkyl, alkoxy and aryloxy.

Preferably, the device has a layered structure and at least one layer comprises at least one compound according to the formulae as disclosed in claim 1.

In one embodiment, R₁, R₂, R₃ and R₄ are independently selected from

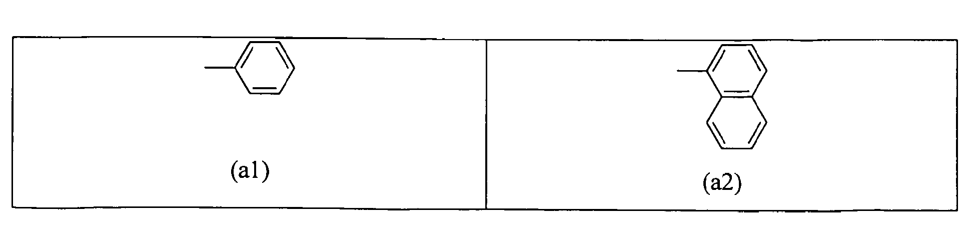

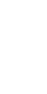

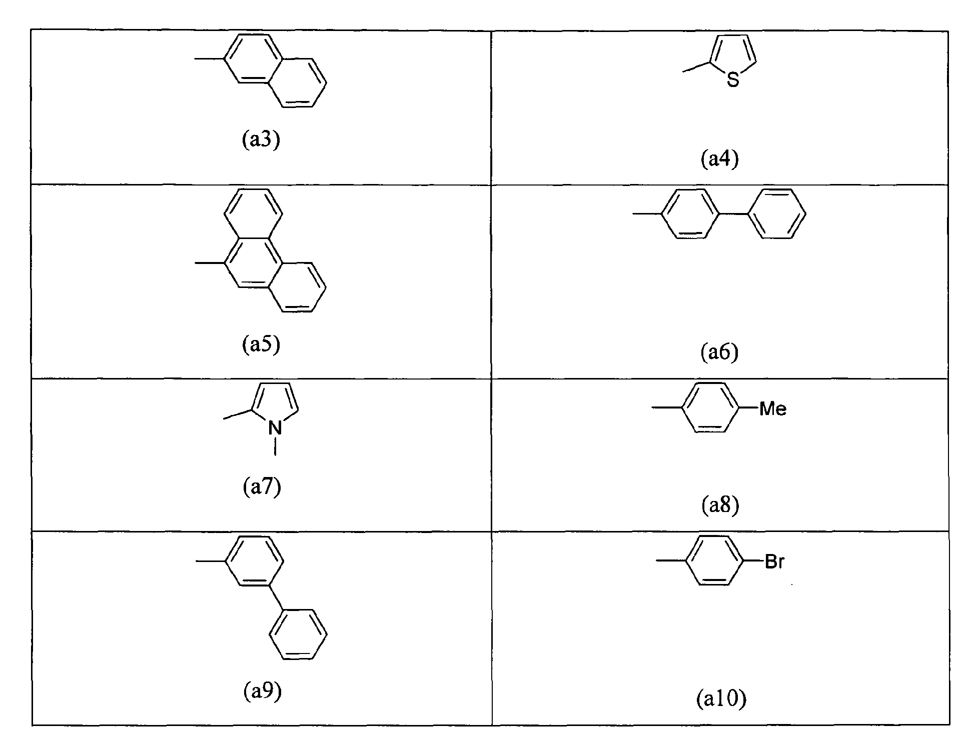

Preferably, the organic semiconducting material is doped by an organic n-dopant which dopant has a HOMO energy level more positive than -3.3 eV.

Even preferred, the organic semiconducting material is doped by an organic n-dopant which dopant is at least one of: 2,2'-diisopropyl-1,1',3,3'-tetramethyl-2,2',3,3',4,4',5,5',6,6',7,7'-dodecahydro-1H, 1'H-2,2-bibenzo[d]imidazole; 4,4',5,5'-tetracyclohexyl-1,1',2,2',3,3'-hexamethyl-2,2',3,3'-tetrahydro-1H,1'H-2,2'-bisimidazole; 2,2'-diisopropyl-4,4',5,5'-tetrakis(4-methoxyphenyl)-1,1',3,3'-tetramethyl-2,2',3,3'-tetrahydro-1H,1'H-2,2'-bisimidazole; 2-isopropyl-1,3-dimethyl-2,3,6,7-tetrahydro-1H-5,8-dioxa-1,3-diaza-cyclopenta[b]naphthene; bis-[1,3-dimethyl-2-isopropyl-1,2-dihydro-benzimidazolyl-(2)]; tetrakis(1,3,4,6,7,8-hexahydro-2H-pyrimido[1,2-a]pyrimidinato)ditungsten (II); 2,2'-diisopropyl-4,5-bis(2-methoxyphenyl)-4',5'-bis(4-methoxyphenyl)-1, 1',3,3'-tetramethyl-2,2',3,3'-tetrahydro- H, 1'H-2,2'- bisimidazole; 2,2'-diisopropyl-4,5-bis(2-methoxyphenyl)-4',5'-bis(3-methoxyphenyl)-1,1',3,3'-tetramethyl - 2,2',3,3'-tetrahydro-1H,1'H-2,2'-bisimidazole.

Preferably, the device is an electronic, optoelectronic or electroluminescent device having an electronically functionally effective region, wherein the electronically effective region comprises at least one compound according to the formulae of claim 1.

Furthermore, the device is preferably an organic light-emitting diode, a field-effect transistor, a sensor, a photodetector, an organic solar cell, an organic thin-film transistor, an organic integrated circuit, an organic field-quench device, an organic light-emitting transistor, a light-emitting electrochemical cell or an organic laser diode. The device may be also an organic-inorganic hybrid device.

Finally, the object can be achieved by use of a compound according to the formulae 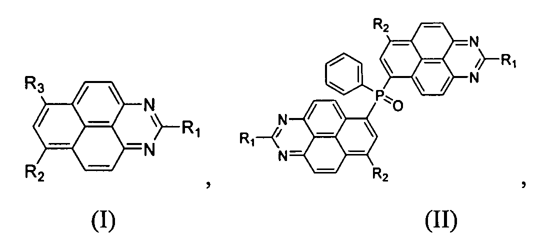 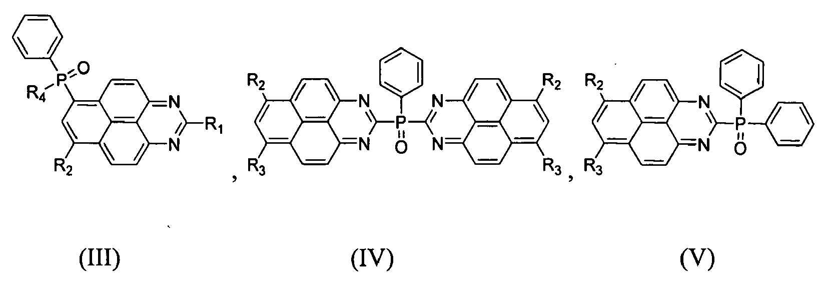 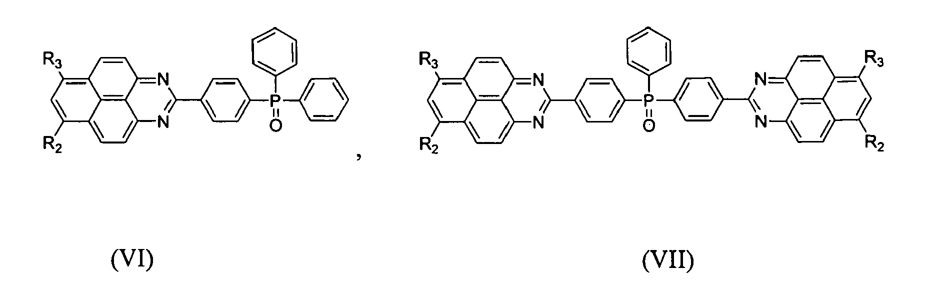 wherein R₁, R₂, R₃, and R₄ are in each occurrence independently selected from H, halogen, CN, substituted or unsubstituted aryl, heteroaryl, alkyl, heteroalkyl, alkoxy and aryloxy,
in an organic electronic device as an optionally doped electron transport layer, an interlayer, a hole blocking layer, an optionally doped buffer layer, an emitter matrix, a semiconducting channel layer, an optionally doped injection layer, an optionally doped pn-transition for combining stacked organic electronic devices, a charge generation layer or a recombination layer.

More preferred are compounds as follows:

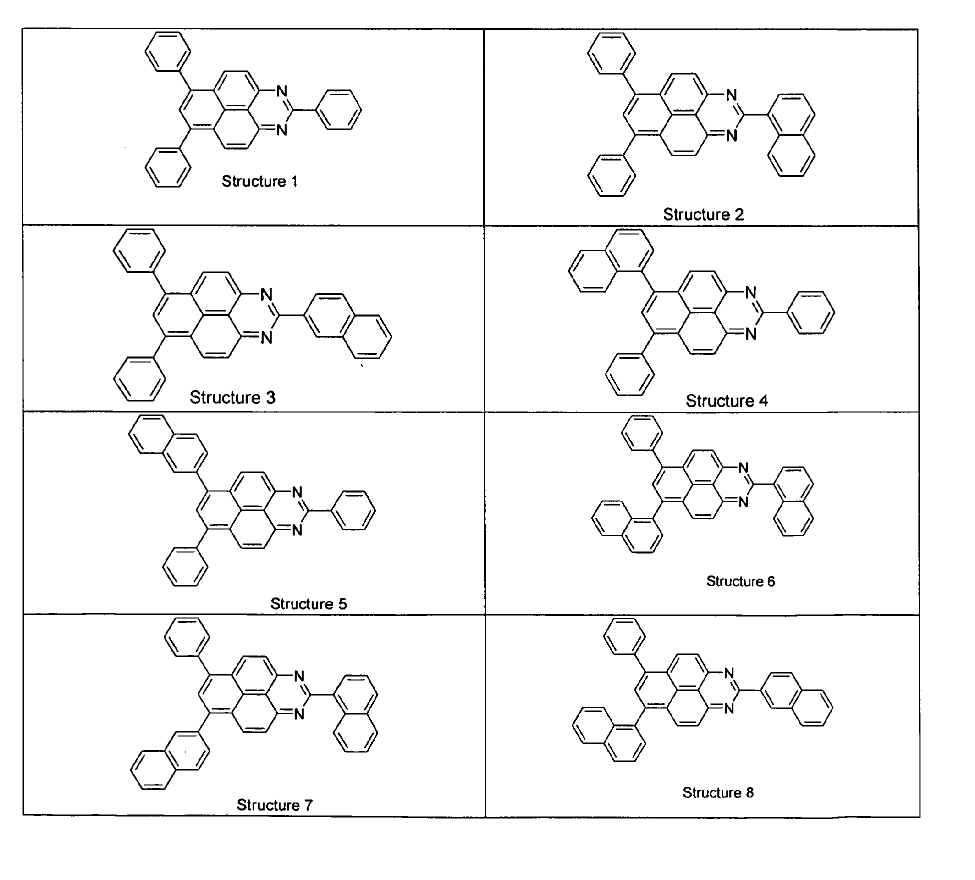

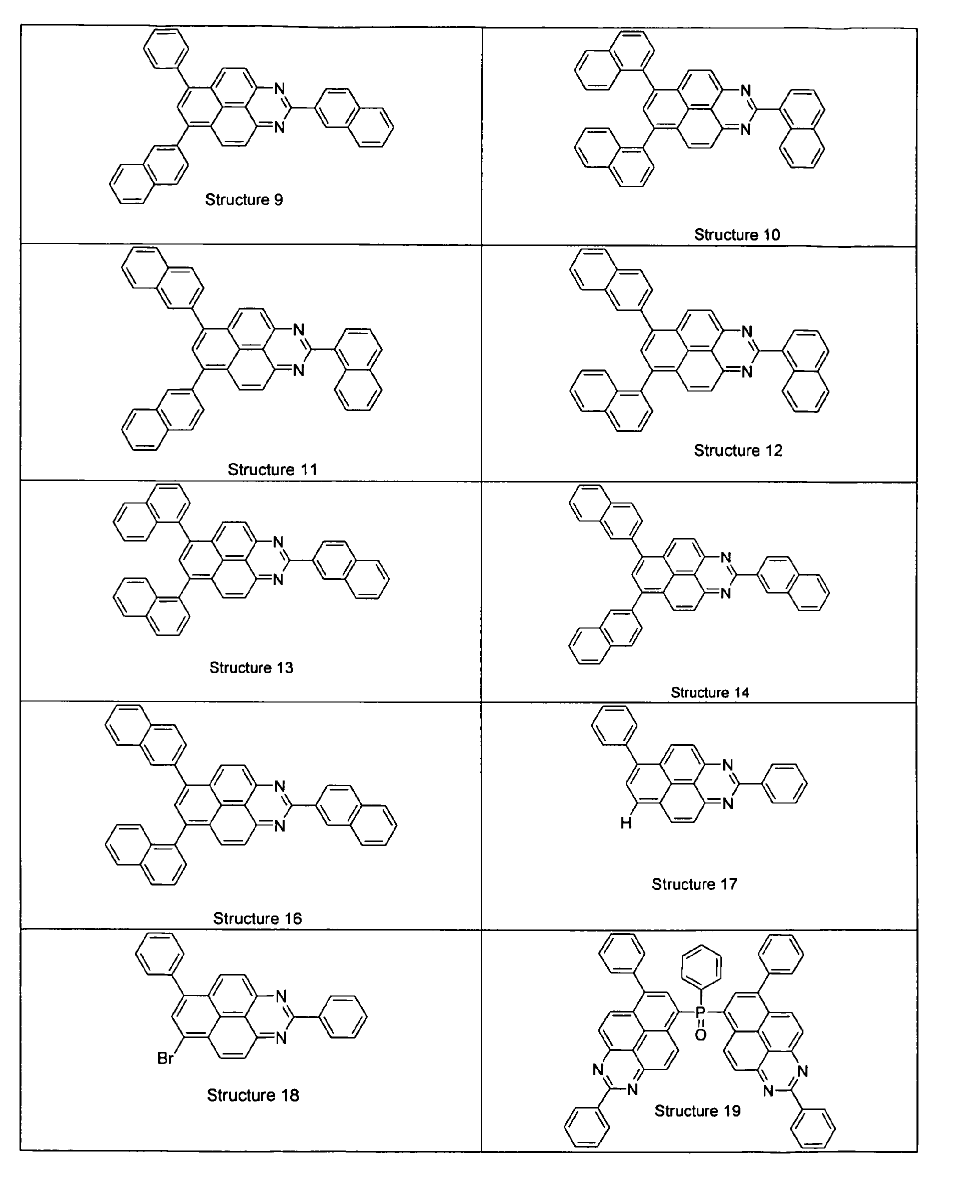

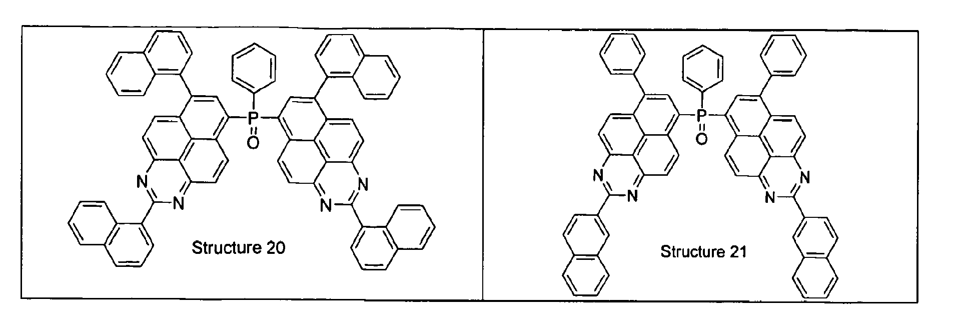

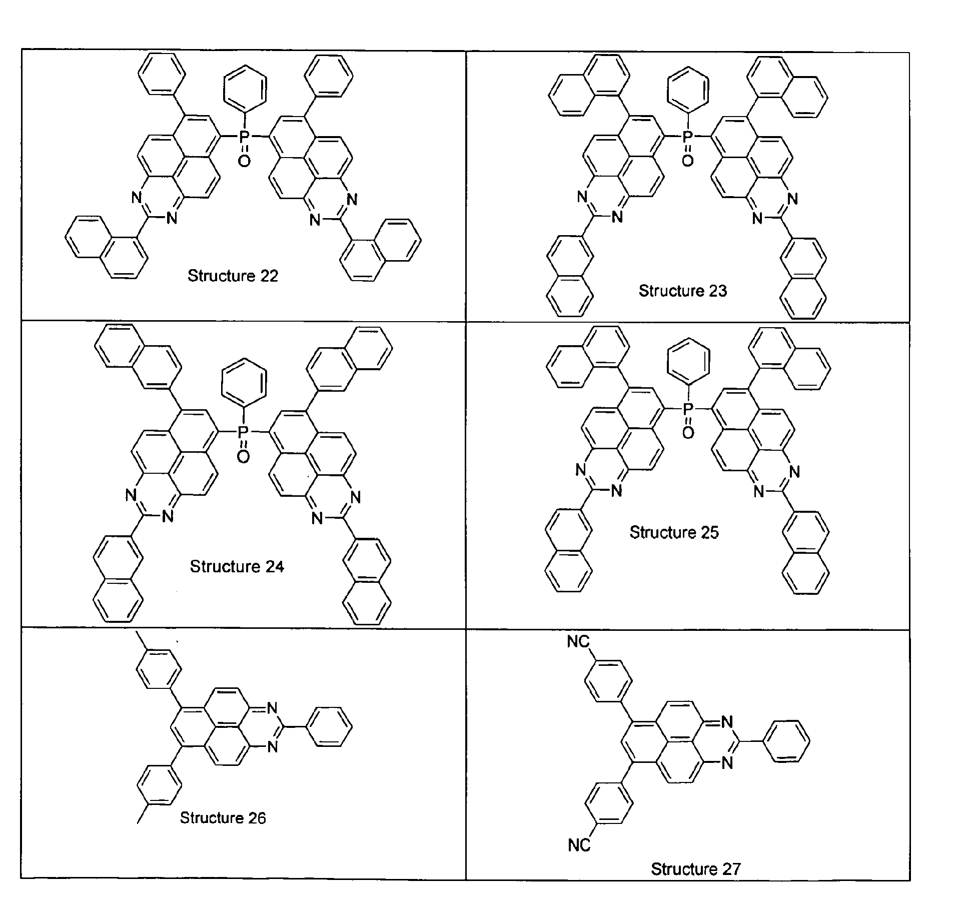

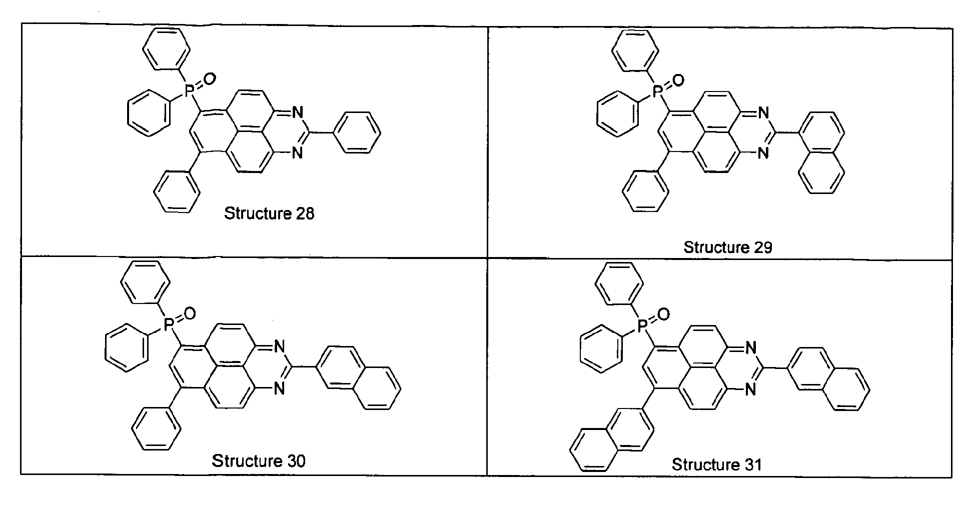

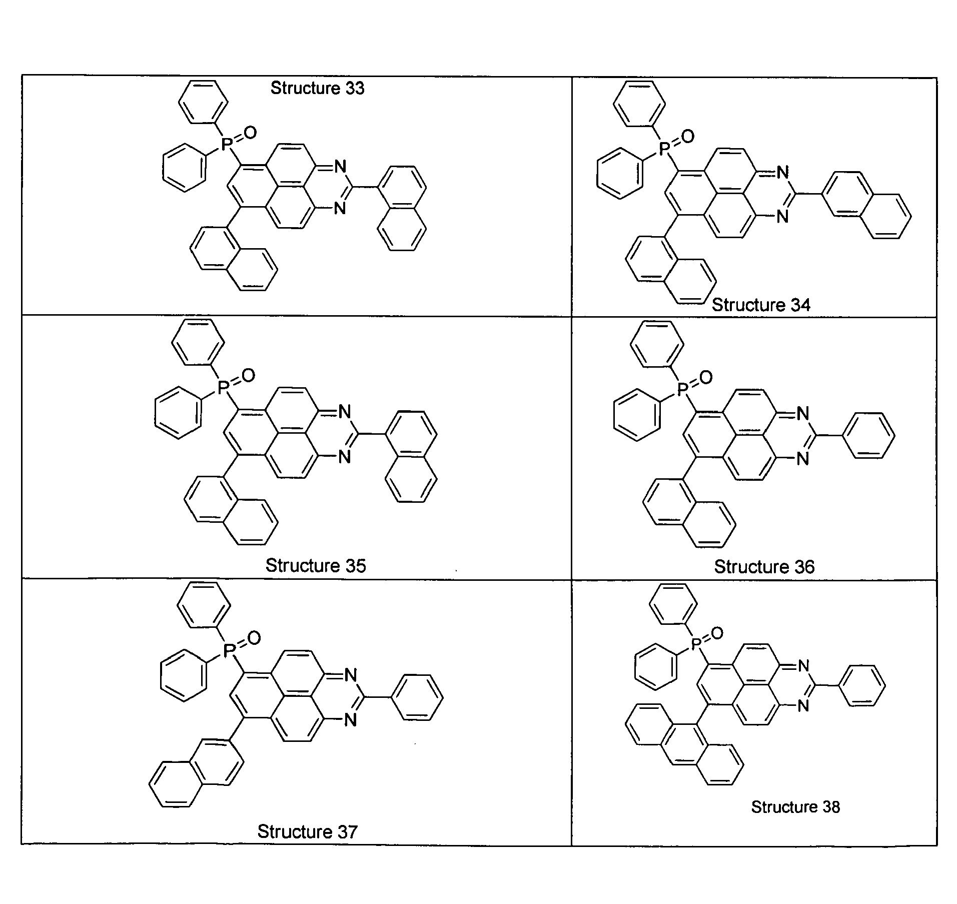

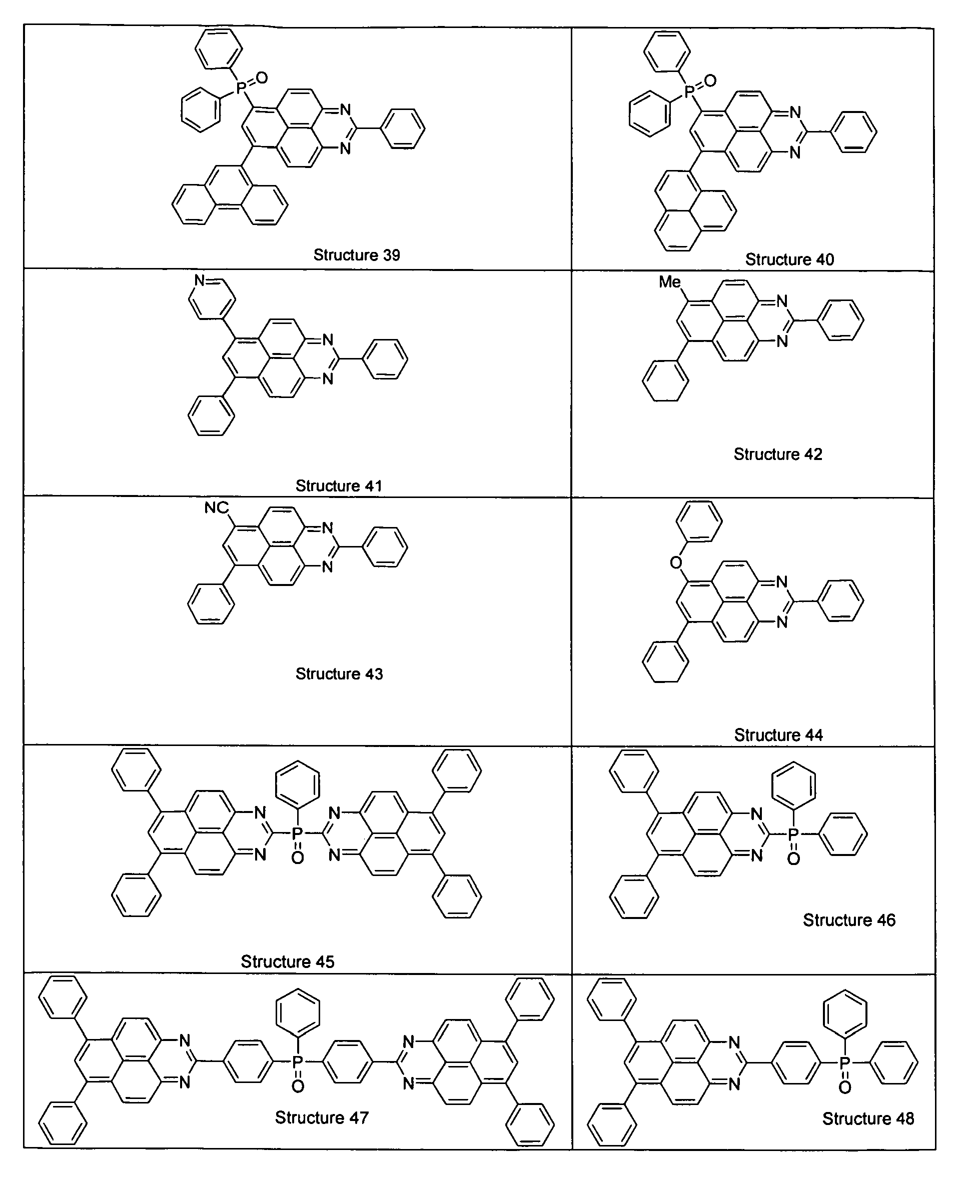

According to the invention is also a device comprising an organic semiconducting material comprising at least one organic matrix material which is optionally doped with at least one dopant, wherein the matrix material comprises a compound according to formulae (I)-(III).

In a light-emitting diode the compounds (I)-(III) can be used in electron transport layers, which might be optionally doped. The compounds can be also used in light-emitting diodes in interlayers such as hole blocking layers. Further, for organic solar cells, the compounds can be used to provide stable electron transport layers (ETL), wherein the ETLs can be further doped. Additionally, the invention provides stable materials for buffer layers for solar cells that can be doped or undoped.

According to the invention, especially a window semiconducting organic material is provided for the device that can be electrically doped achieving a high conductivity while it remains highly transparent in the visible spectra and has a high thermal stability.

According to the invention, also an organic field-effect transistor can be provided comprising at least one compound according to formulae (I)-(III) for use in a transport layer, in other words, in the semiconducting channel layer. An organic field effect transistor may also comprise at least one compound as disclosed as electronically inert buffer layer, when no charge is injected due to high potential barrier. An organic field effect transistor may also comprise at least one compound as disclosed as doped injection layer.

Provided can be also a doped pn-transition in an organic electronic element, for combining stacked organic light-emitting diodes, stacked solar cells and converting contacts to an electrode, respectively, as is, for example, known from EP 1 804 308 or EP 1 808 910.

pn-junctions in OLEDs are also called charge generation layer or connection unit. pn-junctions in organic solar cells are also called recombination layer.

Typically, the organic layer arrangement of an OLED or a solar cell comprises several organic layers which are stacked. Within one organic layer arrangement there may be also provided one or more charge generation layers, such as is known for stacked OLEDs (see EP 1 478 025 A2), wherein such a pn-transition is formed in one embodiment by means of a p-doped hole transport layer and an n-doped electron transport layer which are in direct contact with one another. Such a pn-transition provides a structure generating electric charges, in which, when applying an electrical potential, electrical charges are generated, preferably in the interface area between both layers.

In solar cells and photo sensors the pn-transition is also utilized to combine stacked hetero junctions and to, thus, add voltage generated by this element (US 2006 027 834 A). The charge generation layers have the same function as tunnel-junction in stacked inorganic heterojunction solar cells, although the physical mechanisms may be different.

The charge generation layers are also used to achieve an improved injection (extraction for solar cells) to the electrodes (EP 1 808 910).

For improving the energetic properties in an organic electronic element it was suggested in WO 2005/109 542 A1 to form a pn-transition with one layer of an organic semiconducting material of n-type and one layer of an organic material of p-type, wherein the layer of the organic semiconducting material of n-type is in contact with an electrode formed as an anode. By this, an improved injection of charge carriers in the form of holes into the layer of the organic semiconducting material of p-type is achieved.

The compounds used in this invention according to formulae (I)-(III) can be used in OLEDs in electron transport layers as a neat layer, or as a doped layer in combination with a redox dopant. The compounds can also be used in mixture with other electron transport materials, with other hole transport materials or with other functional materials such as emitter dopants. The compounds can be used as hole blocking layers. Advantageous effects are seen over the prior art since the materials have a higher glass transition temperature compared to materials described in the prior art, such as in DE 10 2007 012 794 or EP 07 400 033.2 (not published yet).

The use of the compounds according to formula (I)-(III) provides high thermal stability, especially due to high glass transition temperature, a good LUMO position for organic light-emitting devices, good dupability, conductivity and charge carrier mobility, high transparency, easy synthesis. Further, preparation of these compounds can be conducted in a very cost-effective manner. Finally, it can be pointed out that the synthesis of such compounds offers a high flexibility to change independently R₁, R₂, R₃ and/or R₄ which opens access to more complex compounds and therefore to different physical/chemical properties resulting in a fine tuning thereof.

It was surprisingly found that especially the thermal stability of doped layers comprising a compound as disclosed can be significantly increased in the devices according to the present invention comprising matrix material. Especially, a glass transition temperature of over 100 °C was achieved with the compound shown in the examples. The combination of such a high glass temperature, the wide gap and the dopability make those compounds to have a high industrial relevance for use in organic electronic devices.

Additional features and advantages of the invention can be taken from the following detailed description of preferred embodiments, together with the drawings as attached.

### Brief description of the drawings

Fig. 1 shows a cross section of a typical small molecule OLED.
Fig. 2 shows a cross section of a typical small molecule organic solar cell.

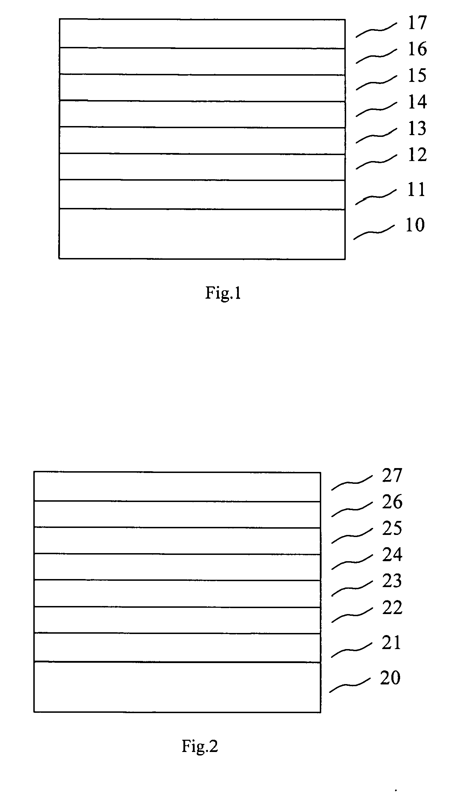

The organic electronic device of the present invention may be an organic light emitting diode. Fig. 1 shows a typical layer structure of an organic light emitting diode. The layers are disposed on a substrate (10) in the following order: anode (11), p-doped hole transport layer (12), electron blocking layer (13), emission layer (14), hole blocking layer (15), n-electron transport layer (16), and cathode (17). Two or more layers can collapse into a smaller number of layers if properties can be combined. Inverted structure and multiple stacked OLEDs are also well known in the field. The emission layer is usually composed by an emitter matrix material and an emitter dopant; this layer can be also composed by several other layers to generate light with a broad spectrum combining several emitters, for example, to generate white light.

Fig.2 shows a typical small molecule organic solar cell. Many variations are possible. One simple structure that offers reasonable efficiencies is composed by a substrate (20), followed by: anode (21), p-doped hole transport layer (22), thin interlayer that is non-doped (23), the photo-active bulk-heterojunction (24), and electron transport layer (25), a buffer layer (26), and the cathode (27).

### Examples

### General synthesis method

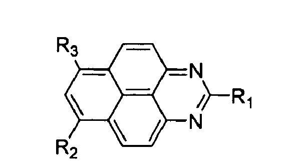

The synthesis of the compounds according to formula (I) uses a 2 step synthetic way. The first part includes the synthesis of a perimidine moiety according to the described procedure from Borolev et al. (Chem. Het. Comp. 2002, 38, 968) and Aksenov et al. (Tetrahedron Lett. 2008, 49, 1808). This first intermediate is obtained by condensation of the appropriate acid chloride (bearing the R1 rest) with 1,8 diaminonaphthalene. This perimidine is then reacted with the appropriate chalcone (bearing the R2 and R3 groups) as described by Borolev et al. (Chem. Het. Comp. 2002, 38, 968). The said chalcone is either purchased or synthesized using the procedure published by Verma et al. (Tetrahedron, 2007, 63, 8715).

Structure (II) can be synthesized according to the synthetic route below:

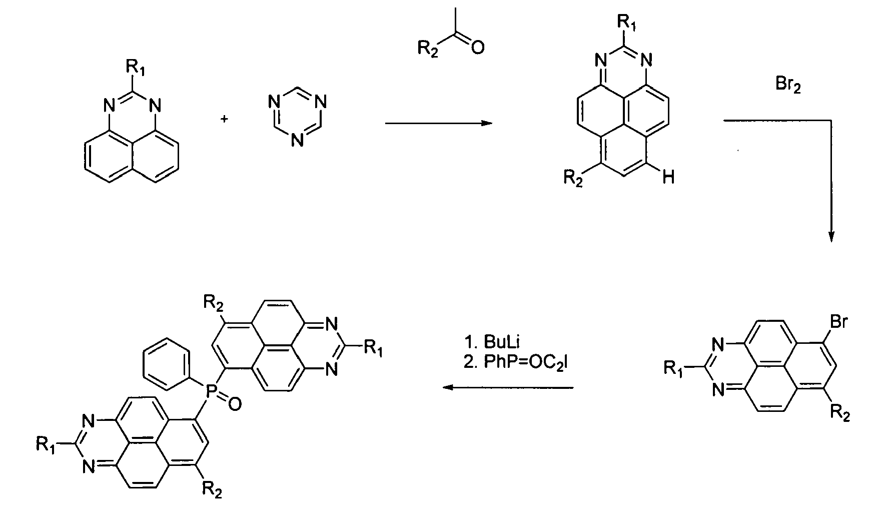

Structure (III) can be synthesized according to the synthetic route below:

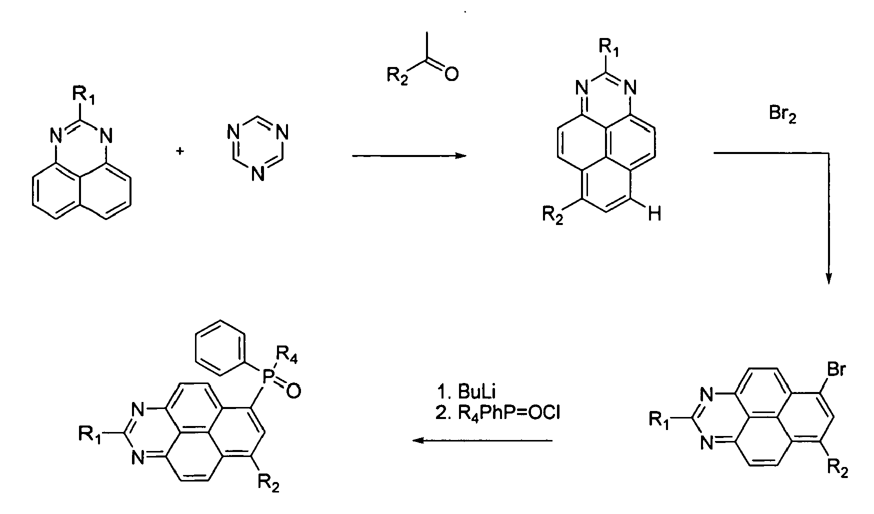

Structure (IV) can be synthesized according to the synthetic route below:

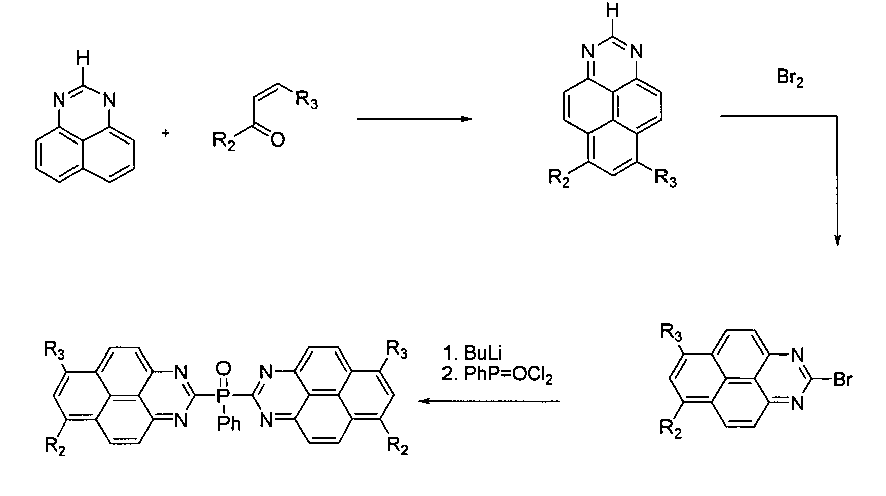

Structure (V) can be synthesized according to the synthetic route below:

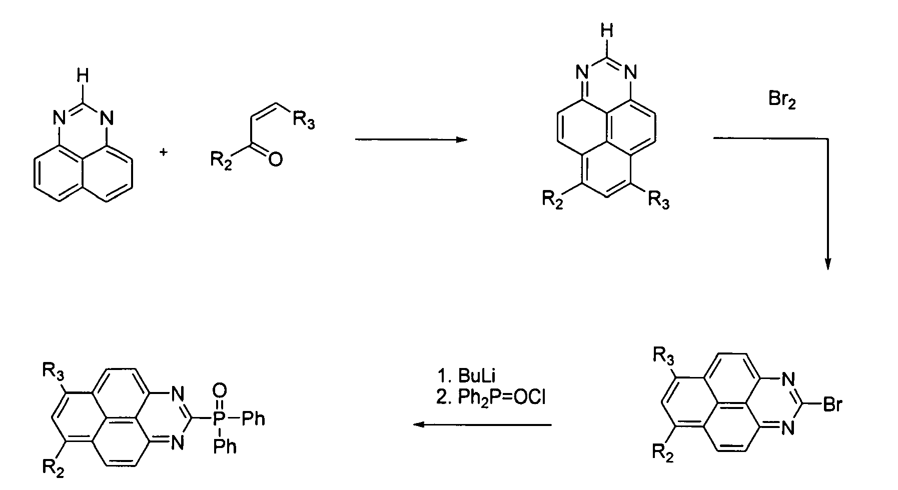

Structure (VI) can be synthesized according to the synthetic route below:

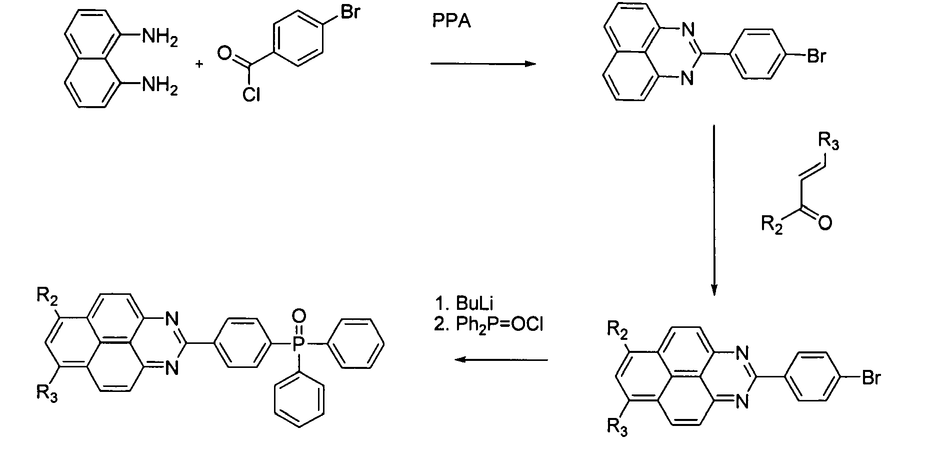

Structure (VII) can be synthesized according to the synthetic route below:

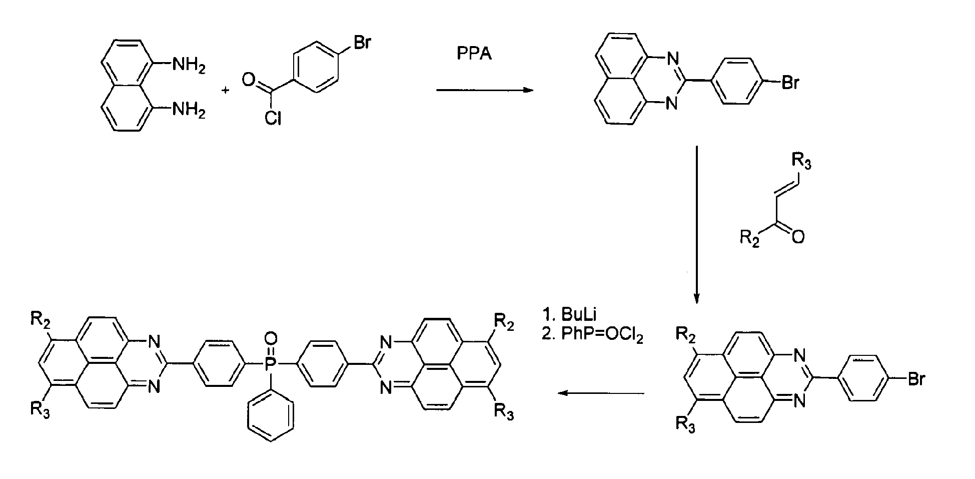

### Example 1

Synthesis of

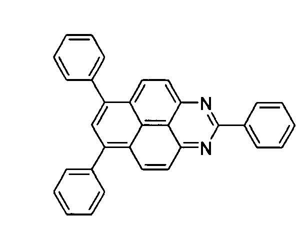

First step: Synthesis of 2-phenyl-1H-perimidine (1). All manipulations were carried out in air, without any further purification of commercial solvents/chemicals. 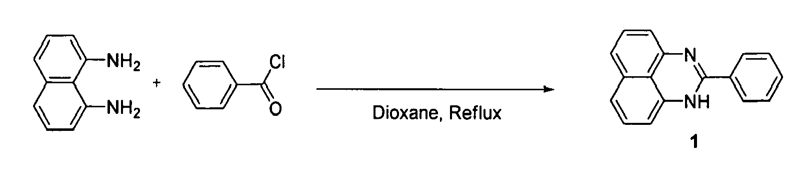 38.2 g (0,24 mol) of 1,8-diaminonaphthalene was solved in 700mL dioxane and 56mL (0.36 mol) benzoyl chloride was added dropwise. After 3 hours at reflux, the mixture was cooled down to room temperature. A precipitate appears and is filtered using a G3 Fritt. The powder is then washed with 100mL dioxane in an almost quantitative yield. The material is then dried in a vacuum oven at 40 °C.

Second step: Synthesis of 2,6,8-triphenylbenzo[gh]perimidine (2). All manipulations were carried out in air, without any further purification of commercial solvents/chemicals. 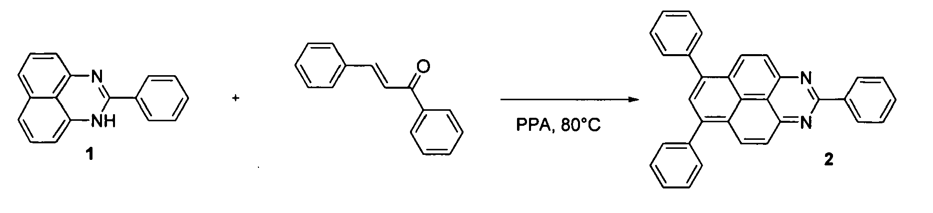 4g (0.016 mol) of 1 and 5.11g (0.0245 mol) of the respective chalcone was suspended in 35g of poly-phosphoric acid. The mixture was stirred using a mechanic stirrer and heated at 65°C. The reaction medium becomes black. After 6h, the reaction medium is poured in 800ml water (at 65°C). A yellow material precipitates. Another 200mL water is then added to the reaction flask to let some more substance precipitate. Both precipitate-containing water phases are treated with a saturated sodium hydroxyde solution to raise the pH to 8-9. The water phase is extracted with 3x100 mL Toluene, and the organic phases are washed with 2x100 mL water and dried over magnesium sulfate. The solution is then concentrated until almost all solvent is evaporated and 50mL of methyl-tert-butylether (MTBE) is added. A beige precipitate appears and is filtered, then washed with 2x10 mL MTBE. The material is then dried using a vacuum oven overnight at 50°C.

Yield: 1.5g,20.8%

Melting Point: 275°C

Glass transition temperature : 102°C

NMR: ¹H NMR (500 MHz, CDCl3) δ 8.81 (d, J = 7.2, 2H), 8.62 (d, J = 9.4, 2H), 8.21 (d, J = 9.4, 2H), 8.09 (s, 1H), 7.72 - 7.43 (m, 13H).

### Example 2

Synthesis of

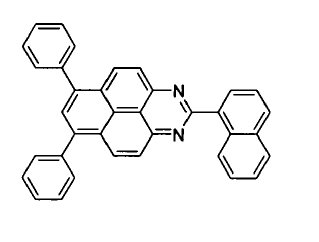

Second step: Synthesis of 2-(naphthalen-1-yl)-6,8-diphenylbenzo[gh]perimidine (4). All manipulations were carried out in air, without any further purification of commercial solvents/chemicals. 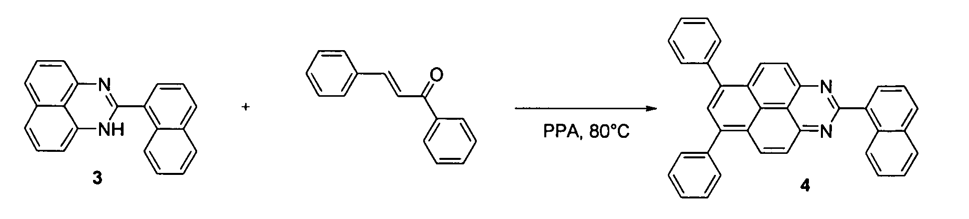 5g (0.017 mol) of 3 and 5,28g (0.0253 mol) of the respective chalcone was suspended in 35g of poly-phosphoric acid. The mixture was stirred using a mechanic stirrer and heated at 65°C. The reaction medium becomes black. After 6h, the reaction medium is poured in 800ml water (at 65°C). A yellow material precipitates. Another 200mL water is then added to the reaction flask to let some more substance precipitate. Both precipitate-containing water phases are treated with a saturated sodium hydroxyde solution to raise the pH to 8-9. The water phase is extracted with 3x100 mL Toluene, and the organic phases are washed with 2x100 mL water and dried over magnesium sulfate. The solution is then concentrated until almost all solvent is evaporated and 50mL of methyl-tert-butylether (MTBE) is added. A beige precipitate appears and is filtered, then washed with 2x10 mL MTBE. The material is then dried using a vacuum oven overnight at 50°C.

Yield: 2.7g, 33 %

Melting Point: 289°C

Glass transition temperature: 109°C

NMR: ¹H NMR (500 MHz, CDCl3) δ 8.73 (d, J = 9.4, 2H), 8.67 (dd, J = 3.5, 6.0, 1H), 8.32 (d, J = 9.4, 2H), 8.24 (dd, J = 0.9, 7.1, 1H), 8.17 (s, 1H), 8.01 (d, J = 8.2, 1H), 7.97 - 7.88 (m, 1H), 7.74 - 7.48 (m, 13H)..

### Example of a conductive layer

The conductivity of a doped layer consisting of material of example 2 doped with 10% of W(hpp)₄ was measured at room temperature and was 1.6x10⁻⁵ S/cm. The layer remained conductive until the layer temperature reached 113 °C.

### Example of an organic solar cell

Device 1 (comparative). A state of the art organic solar cell was fabricated with the following procedure: patterned glass substrate coated with ITO was cleaned in an ultrasound bath with etanol, acetone and isopropanol. Afterwards the ITO substrate was exposed to oxygen plasma treatment for 15 minutes. The substrate was loaded into the vacuum trough a glove box with nitrogen. In vacuum the organic layers were deposited with conventional VTE (vacuum thermal evaporation). First a 10 nm thick 5% (molar) p-doped CuPc layer was deposited through a shadow mask over the ITO. A 10 nm undoped CuPc layer was deposited over the doped CuPc layer. A 30 nm thick mixed layer of fullerene C60 and CuPc was deposited with a molar ratio of 2(C60):1(CuPc). A 40 nm thick C60 layer was deposited on top of the mixed layer. A 10 nm BPhen (4,7-diphyenyl-1,10-phenanthroline) layer was deposited on top of the C60 layer. The BPhen layer is followed by a 100 nm thick A1 cathode. Under standard simulated AM 1.5 (Air Mass 1.5) solar spectra, the device shows a short circuit current of 8 mA/cm², a FF of 41 % and an open circuit voltage of 0.5 V.

Device 2. An inventive organic solar cell was made with the same layer structure as device 1 except that a 10 nm thick layer of the compound of example 2 was used instead of the BPhen layer. Under standard simulated AM1.5 the device shows a short circuit current of 8 mA/cm², a FF of 42 % and an open circuit voltage of 0.48 V.

The small differences in the characteristic photo conversion parameters are considered as normal fluctuations; basically the two devices have the same photoelectrical conversion performance. Both devices were submitted to thermal stress: the temperature was increased by 1 °C followed by a pause of 20 seconds and an I-V curve measurement. The procedure was repeated increasing the temperature by 1 °C in each step. The device 1 stopped to work at 67 °C, the I-V curve turned very flat, the FF dropped to 25 %. Device 2 kept working at least until 80 °C, after that the measurement was stopped.

### Example of an OLED

### Device 3

An OLED was fabricated with the following procedure: A glass substrate coated with ITO (90 nm thick, pre-patterned) was cleaned in organic solvents in conventional ultra-sound. Afterwards the substrate was treated with ozone plasma for 5 minutes. After the cleaning, the substrate was transferred to vacuum. The organic layers were deposited in high vacuum (base pressure lower than 10⁻³ Pa) by conventional VTE (Vacuum thermal evaporation). The deposited area was defined by a shadow mask, keeping some area of the ITO surface free so that an electrical contact for the measurements could (later on) be established. The organic layer sequence over the ITO layer is: 50 nm thick NPD layer doped with 2,2'-(perfluoronaphthalene-2,6-diylidene) dimalononitrile; 10 nm thick non-doped NPD layer, 20 nm thick rubrene emitter layer doped with a fluorescent emitter; 10 nm ETL (structure 8), 60 nm ETL (structure 8) doped with W(hpp)₄ (10 % in weight). A 100 nm aluminum layer was deposited as cathode. The OLED reached 1000 cd/m² at 2.8 V.

The features disclosed in the foregoing description and in the claims may, both separately and in any combination thereof, be material for realizing the invention in diverse forms thereof.

## Claims

1. Organic electronic device comprising an organic semiconducting material comprising at least one compound according to the following formulae: 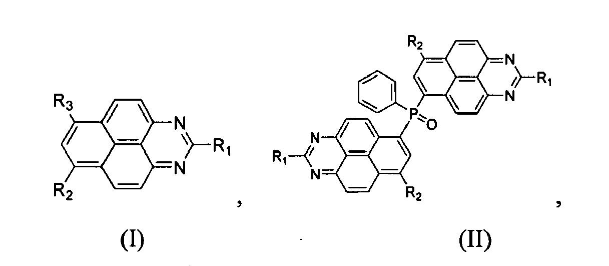 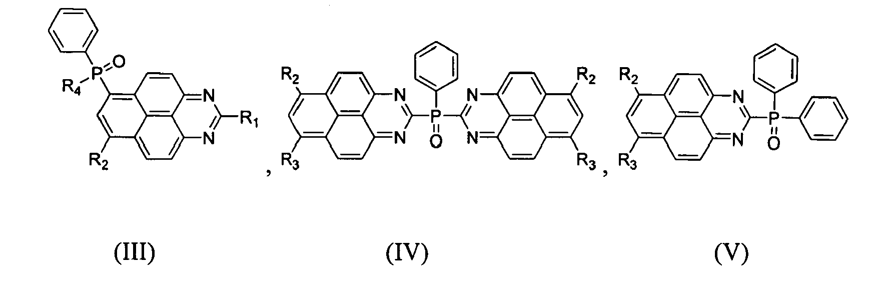 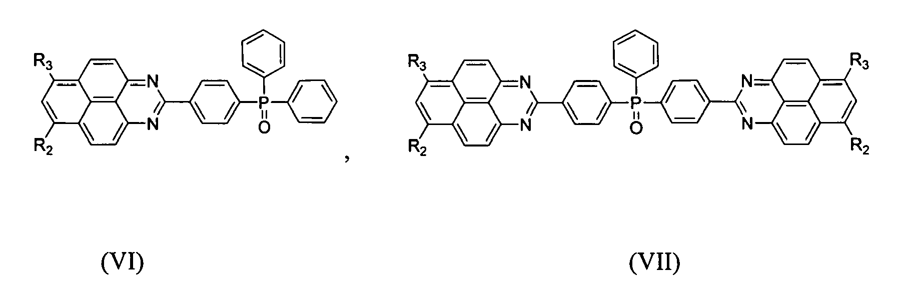 wherein R₁, R₂, R₃, and R₄ are in each occurrence independently selected from H, halogen, CN, substituted or unsubstituted aryl, heteroaryl, alkyl, heteroalkyl, alkoxy and aryloxy.

2. Organic electronic device according to claim 1, wherein the device has a layered structure and at least one layer comprises at least one compound according to the formulae as disclosed in claim 1.

3. Organic electronic device according to claim 1, wherein R₁, R₂, R₃, and R₄ are independently selected from

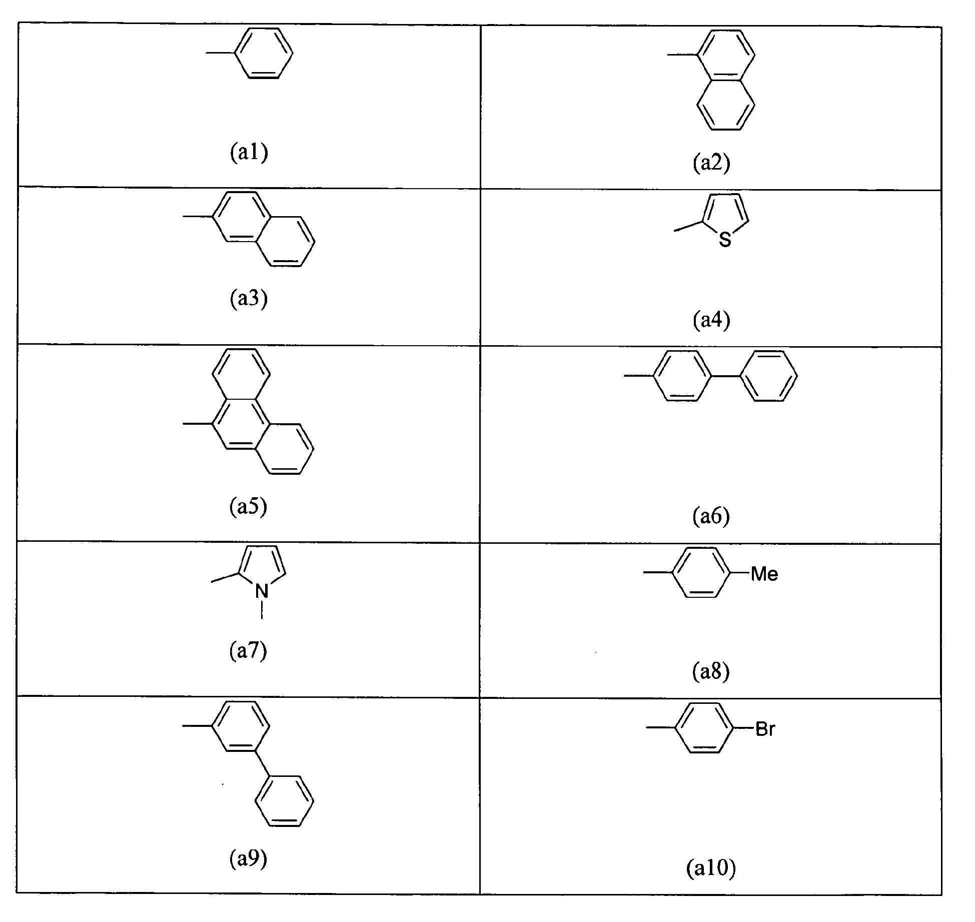

4. Organic electronic device according to claim 1, wherein the organic semiconducting material is doped by an organic n-dopant which dopant has a HOMO energy level more positive than -3.3 eV.

5. Organic electronic device according to claim 1, wherein the organic semiconducting material is doped by an organic n-dopant which dopant is at least one of: 2,2'-diisopropyl-1,1',3,3'-tetramethyl-2,2',3,3',4,4',5,5',6,6',7,7'-dodecahydro-1H, 1'H-2,2-bibenzo[d]imidazole; 4,4',5,5'-tetracyclohexyl-1,1',2,2',3,3'-hexamethyl-2,2',3,3'-tetrahydro-1H,1'H-2,2'-bisimidazole; 2,2'-diisopropyl-4,4',5,5'-tetrakis(4-methoxyphenyl)-1,1',3,3'-tetramethyl-2,2',3,3'-tetrahydro-1H,1'H-2,2'-bisimidazole; 2-isopropyl-1,3-dimethyl-2,3,6,7-tetrahydro-1H-5,8-dioxa-1,3-diaza-cyclopenta[b]-naphthene; bis-[1,3-dimethyl-2-isopropyl-1,2-dihydro-benzimidazolyl-(2)]; tetrakis(1,3,4,6,7,8-hexahydro-2H-pyrimido[1,2-a]pyrimidinato)ditungsten (II); 2,2'-diisopropyl-4,5-bis(2-methoxyphenyl)-4',5'-bis(4-methoxyphenyl)-1,1',3,3'-tetramethyl-2,2',3,3'-tetrahydro-1H,1'H-2,2'- bisimidazole; 2,2'-diisopropyl-4,5-bis(2-methoxyphenyl)-4',5'-bis(3-methoxyphenyl)-1,1',3,3'-tetramethyl - 2,2',3,3'-tetrahydro-1H,1'H-2,2'-bisimidazole.

6. Organic electronic device according to claim 1, wherein the device is an electronic, optoelectronic or electroluminescent device having an electronically functionally effective region, wherein the electronically effective region comprises at least one compound according to the formulae of claim 1.

7. Organic electronic device according to any of the preceding claims, wherein the device is an organic light-emitting diode, a field-effect transistor, a sensor, a photodetector, an organic solar cell, an organic thin-film transistor, an organic integrated circuit, an organic field-quench device, an organic light-emitting transistor, a light-emitting electrochemical cell or an organic laser diode.

8. Use of a compound according to the formulae 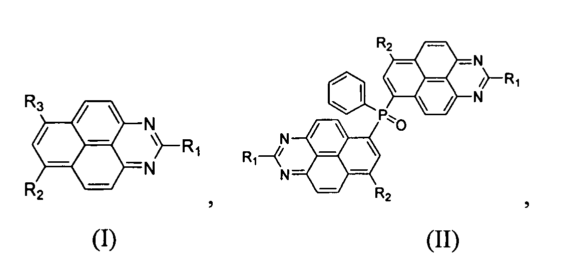 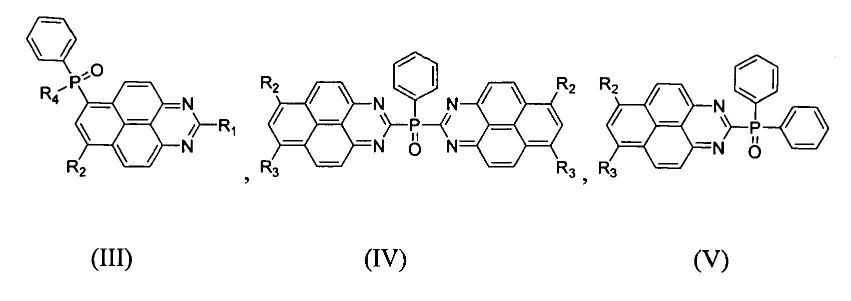 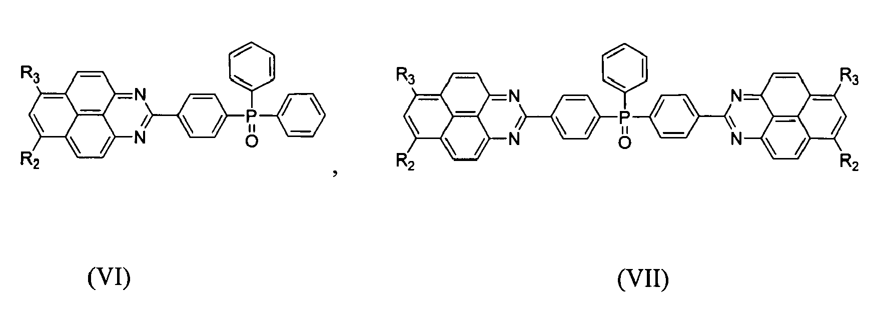 wherein R₁, R₂, R₃, and R₄ are in each occurrence independently selected from H, halogen, CN, substituted or unsubstituted aryl, heteroaryl, alkyl, heteroalkyl, alkoxy and aryloxy,
in an organic electronic device as an optionally doped electron transport layer, an interlayer, a hole blocking layer, an optionally doped buffer layer, an emitter matrix, a semiconducting channel layer, an optionally doped injection layer, an optionally doped pn-transition for combining stacked organic electronic devices, a charge generation layer or a recombination layer.
